# EUROPEAN PATENT APPLICATION

(11) **EP 4 645 294 A1**
(43) Date of publication of application: **05.11.2025**
(21) Application number: 25172882.0
(22) Date of filing: 28.04.2025
(51) Int. Cl.: G09G 3/32, G09G 3/20

(54) **PIXEL CIRCUIT, DISPLAY APPARATUS INCLUDING THE SAME AND ELECTRONIC APPARATUS INCLUDING THE SAME**

(30) Priority: 02.05.2024 KR 20240058756
(71) Applicant: Samsung Display Co., Ltd., Yongin-si, Gyeonggi-do 17113 (KR)
(72) Inventor: KIM, Kwihyun, 17113 Yongin-si (KR); LEE, Sehyun, 17113 Yongin-si (KR); CHANG, Haksun, 17113 Yongin-si (KR)
(74) Representative: Walaski, Jan Filip

(57) **Abstract**

A pixel circuit includes a first transistor (T1) including a control electrode connected to a first node (N1), a first electrode connected to a second node (N2), and a second electrode connected to a third node (N3), a second transistor (T2) connected to the first node and the second node, a third transistor (T3) configured to apply a data voltage (VDATA) to the first transistor, a seventh transistor (T7) connected to a fourth node (N4), and configured to apply a driving current to a light-emitting element (EE), a ninth transistor (T9) configured to apply a constant-current voltage to the fourth node, and the light-emitting element configured to emit a light based on the data voltage and the constant-current voltage, wherein the first transistor, the second transistor, the third transistor, the seventh transistor, and the ninth transistor include N-type transistors.

## Description

### BACKGROUND

### 1. Field

The present disclosure relates to a pixel circuit able to be driven in a pulse width modulation method, able to operate an internal compensation of a threshold voltage, including fewer transistors, and applicable to a high resolution display apparatus, a display apparatus including the pixel circuit, and an electronic apparatus including the pixel circuit.

### 2. Description of the Related Art

Generally, a display apparatus includes a display panel and a display panel driver. The display panel includes a plurality of gate lines, a plurality of data lines and a plurality of pixels. The display panel driver includes a gate driver, a data driver, and a driving controller. The gate driver outputs gate signals to the gate lines. The data driver outputs data voltages to the data lines. The driving controller controls the gate driver and the data driver.

A conventional pixel circuit driven in a pulse width modulation method and operating internal compensation of the threshold voltage may include nineteen or more transistors and three or more capacitors. When the pixel circuit includes nineteen or more transistors and three or more capacitors, the pixel circuit may not be applied to an ultra-high resolution display apparatus due to a limitation in integration.

In addition, a driving transistor of a pulse width modulation circuit of the conventional pixel circuit is a P-type transistor so that an afterimage characteristic, a response time characteristic when changing from a black image to a white image, and a luminance-changing-rate characteristic according to a temperature, may be deteriorated or degraded.

### SUMMARY

Embodiments of the present disclosure provide a pixel circuit driven in a pulse width modulation method, operating an internal compensation of a threshold voltage, including fewer transistors, and thus, applicable to an ultra-high resolution display apparatus and including only N-type transistors.

Embodiments of the present disclosure also provide a display apparatus including the pixel circuit.

Embodiments of the present disclosure also provide an electronic apparatus including the pixel circuit.

In one or more embodiments of a pixel circuit according to the present disclosure, the pixel circuit includes a first transistor including a control electrode connected to a first node, a first electrode connected to a second node, and a second electrode connected to a third node, a second transistor connected to the first node and the second node, a third transistor configured to apply a data voltage to the first transistor, a seventh transistor connected to a fourth node, and configured to apply a driving current to a light-emitting element, a ninth transistor configured to apply a constant-current voltage to the fourth node, and the light-emitting element configured to emit a light based on the data voltage and the constant-current voltage, wherein the first transistor, the second transistor, the third transistor, the seventh transistor, and the ninth transistor include N-type transistors.

The pixel circuit may further include a sixth transistor including a control electrode configured to receive a first initialization signal, a first electrode connected to the first node, and a second electrode connected to a first initialization voltage terminal and to a second electrode of the ninth transistor.

The pixel circuit may further include a first capacitor including a first electrode configured to receive a sweep signal, and a second electrode connected to the first node.

The pixel circuit may further include a fourth transistor including a control electrode configured to receive a first emission signal, a first electrode configured to receive a first power voltage, and a second electrode connected to the second node, and a fifth transistor including a control electrode configured to receive a second emission signal, a first electrode connected to the third node, and a second electrode connected to the fourth node.

The pixel circuit may further include an eighth transistor including a control electrode configured to receive a first emission signal, a first electrode connected to a second electrode of the seventh transistor, and a second electrode connected to an anode electrode of the light-emitting element.

The pixel circuit may further include an eighth transistor including a control electrode configured to receive a first emission signal, a first electrode configured to receive a second power voltage, and a second electrode connected to a first electrode of the seventh transistor.

The pixel circuit may further include a tenth transistor including a control electrode configured to receive a second initialization signal, a first electrode connected to an anode electrode of the light-emitting element, and a second electrode configured to receive a second initialization voltage.

The pixel circuit may further include a second capacitor including a first electrode connected to the fourth node, and a second electrode connected to a second electrode of the seventh transistor.

The pixel circuit may further include a third capacitor including a first electrode configured to receive a second power voltage, and a second electrode connected to the fourth node.

The first transistor may be configured to be turned off, the seventh transistor is configured to be turned on, and the light-emitting element is configured to emit a light in a light-emission period, wherein the first transistor is configured to be turned on, the seventh transistor is configured to be turned off, and the light-emitting element is configured to stop emitting light in a light-emission-off period.

The pixel circuit may further include a fourth transistor including a control electrode configured to receive a first emission signal, a first electrode configured to receive a first power voltage, and a second electrode connected to the second node, wherein a second power voltage is configured to be applied to a first electrode of the seventh transistor, and wherein the first power voltage is greater than the second power voltage.

The pixel circuit may further include a tenth transistor including a control electrode configured to receive a second initialization signal, a first electrode connected to an anode electrode of the light-emitting element, and a second electrode configured to receive a second initialization voltage, wherein a third power voltage is configured to be applied to a cathode electrode of the light-emitting element, and wherein the second initialization voltage is less than the third power voltage.

The second transistor may include a control electrode configured to receive a first scan signal, a first electrode connected to the first node, and a second electrode connected to the second node, wherein the third transistor includes a control electrode configured to receive the first scan signal, a first electrode configured to receive the data voltage, and a second electrode connected to the third node, wherein the seventh transistor includes a control electrode connected to the fourth node, a first electrode configured to receive a second power voltage, and a second electrode connected to a fifth node, wherein the ninth transistor includes a control electrode configured to receive a second scan signal, a first electrode connected to the fourth node, and a second electrode connected to a first initialization voltage terminal, and wherein the light-emitting element includes an anode electrode, and a cathode electrode configured to receive a third power voltage.

The pixel circuit may further include a fourth transistor including a control electrode configured to receive a first emission signal, a first electrode configured to receive a first power voltage, and a second electrode connected to the second node, a fifth transistor including a control electrode configured to receive a second emission signal, a first electrode connected to the third node, and a second electrode connected to the fourth node, a sixth transistor including a control electrode configured to receive a first initialization signal, a first electrode connected to the first node, and a second electrode connected to the first initialization voltage terminal, an eighth transistor including a control electrode configured to receive the first emission signal, a first electrode connected to the fifth node, and a second electrode connected to the anode electrode of the light-emitting element, a tenth transistor including a control electrode configured to receive a second initialization signal, a first electrode connected to the anode electrode of the light-emitting element, and a second electrode configured to receive a second initialization voltage, a first capacitor including a first electrode configured to receive a sweep signal, and a second electrode connected to the first node, and a second capacitor including a first electrode connected to the fourth node, and a second electrode connected to the fifth node.

The fourth transistor, the fifth transistor, the sixth transistor, the eighth transistor, and the tenth transistor may include N-type transistors.

The first initialization signal may have an active level in a first period, wherein the second initialization signal has an active level in the first period, wherein the first scan signal has an inactive level in the first period, wherein the second scan signal has an inactive level in the first period, wherein the first emission signal has an active pulse in the first period, wherein the second emission signal has an inactive level in the first period, wherein the sweep signal has a low level in the first period, and wherein a voltage outputted from the first initialization voltage terminal has a first level in the first period.

The first initialization signal may have an inactive level in a second period, wherein the second initialization signal has an active level in the second period, wherein the first scan signal has an active pulse in the second period, wherein the second scan signal has an inactive level in the second period, wherein the first emission signal has an inactive level in the second period, wherein the second emission signal has an inactive level in the second period, and wherein the sweep signal has a low level in the second period.

The first initialization signal may have an inactive level in a third period, wherein the second initialization signal has an active level in the third period, wherein the first scan signal has an inactive level in the third period, wherein the second scan signal has an active level in the third period, wherein the first emission signal has an inactive level in the third period, wherein the second emission signal has an active level in the third period, wherein the sweep signal has a low level in the third period, and wherein a voltage outputted from the first initialization voltage terminal has a second level in the third period.

The first initialization signal may have an inactive level in a fourth period and a fifth period, wherein the second initialization signal has an inactive level in the fourth period and the fifth period, wherein the first scan signal has an inactive level in the fourth period and the fifth period, wherein the second scan signal has an inactive level in the fourth period and the fifth period, wherein the first emission signal has an active level in the fourth period and the fifth period, wherein the second emission signal has an active level in the fourth period and the fifth period, and wherein the sweep signal is configured to gradually increase from a low level in the fourth period and the fifth period.

The first initialization signal may have an active level in a first period, wherein the second scan signal has an active level in a third period, and wherein a voltage outputted from the first initialization voltage terminal has a first level in the first period, and a second level different from the first level in the third period.

The second scan signal may have an active level in a third period, wherein the first emission signal has an inactive level in the third period, and wherein the second emission signal has an active level in the third period.

The data voltage may be applied to the first transistor, and the light-emitting element may be configured to emit light, in a writing frame, wherein the first initialization signal has an active level in a first period of the writing frame, wherein the first scan signal has an active pulse in a second period of the writing frame, wherein the data voltage is not applied to the first transistor, and the light-emitting element is configured to emit a light, in a holding frame, wherein the first initialization signal has an inactive level in a first period of the holding frame, and wherein the first scan signal has an inactive level in a second period of the holding frame.

The first initialization signal, the second initialization signal, the first scan signal, the second scan signal, the first emission signal, the second emission signal, and the sweep signal may be configured to be progressively applied to pixel rows.

In one or more embodiments of a display apparatus according to the present disclosure, the display apparatus includes a display panel including a pixel circuit, a gate driver configured to output a gate signal to the pixel circuit, and a data driver configured to output a data voltage to the pixel circuit, wherein the pixel circuit includes a first transistor including a control electrode connected to a first node, a first electrode connected to a second node, and a second electrode connected to a third node, a second transistor connected to the first node and to the second node, a third transistor configured to apply the data voltage to the first transistor, a seventh transistor connected to a fourth node, and configured to apply a driving current to a light-emitting element, a ninth transistor configured to apply a constant-current voltage to the fourth node, and the light-emitting element configured to emit a light based on the data voltage and the constant-current voltage, and wherein the first transistor, the second transistor, the third transistor, the seventh transistor, and the ninth transistor include N-type transistors.

In one or more embodiments of an electronic apparatus according to the present disclosure, the electronic apparatus includes a display panel including a pixel circuit, a gate driver configured to output a gate signal to the pixel circuit, a data driver configured to output a data voltage to the pixel circuit, a driving controller configured to control the gate driver and the data driver, and a processor configured to output input image data and an input control signal to the driving controller, wherein the pixel circuit includes a first transistor including a control electrode connected to a first node, a first electrode connected to a second node, and a second electrode connected to a third node, a second transistor connected to the first node and the second node, a third transistor configured to apply the data voltage to the first transistor, a seventh transistor connected to a fourth node and configured to apply a driving current to a light-emitting element, a ninth transistor configured to apply a constant-current voltage to the fourth node, and the light-emitting element configured to emit a light based on the data voltage and the constant-current voltage, and wherein the first transistor, the second transistor, the third transistor, the seventh transistor, and the ninth transistor include N-type transistors.

According to the pixel circuit, the display apparatus including the pixel circuit, and the electronic apparatus including the pixel circuit, the pixel circuit may include ten transistors and two capacitors. The pixel circuit may be driven in the pulse width modulation method, may operate the internal compensation of the threshold voltage and may include the relatively fewer transistors compared to the conventional pixel circuit, so that the high integration may be achieved. Thus, the pixel circuit may be applicable to an ultra-high resolution display apparatus.

In addition, the driving transistor of the pulse width modulation circuit is an N-type transistor, so that an afterimage characteristic, a response time characteristic when changing from a black image to a white image, and/or a luminance-changing-rate characteristic according to a temperature may be enhanced.

In addition, the driving transistor of the constant-current-generating circuit is an N-type transistor so that the afterimage characteristic, the response time characteristic when changing from the black image to the white image, and the luminance-changing-rate characteristic according to the temperature may be enhanced.

In addition, the pixel circuit may omit P-type transistors, and may include only N-type transistors, so that a manufacturing process may be simplified compared to a manufacturing process of a pixel circuit including both an N-type transistor and a P-type transistor.

In addition, the second initialization voltage applied to the second electrode of the tenth transistor is less than the third power voltage applied to the cathode electrode of the light-emitting element so that a black characteristic of the pixel circuit may be enhanced.

In addition, the first initialization voltage applied to the control electrode of the first transistor and a constant-current voltage applied to the control electrode of the seventh transistor are outputted from the same voltage terminal, so that a number of transistors and a number of signal lines may be reduced.

### BRIEF DESCRIPTION OF THE DRAWINGS

The above and other aspects of the embodiments will become more apparent by describing in detailed embodiments thereof with reference to the accompanying drawings, in which:
FIG. 1 is a block diagram illustrating a display apparatus;
FIG. 2 is a circuit diagram illustrating a pixel circuit of the display panel of FIG. 1;
FIG. 3 is a circuit diagram illustrating an operation of the pixel circuit of FIG. 2 in a first period of a driving timing;
FIG. 4 is a timing diagram illustrating an example of input signals applied to the pixel circuit of FIG. 2 and node signals of the pixel circuit of FIG. 2 in the first period;
FIG. 5 is a circuit diagram illustrating an operation of the pixel circuit of FIG. 2 in a second period of the driving timing;
FIG. 6 is a timing diagram illustrating an example of input signals applied to the pixel circuit of FIG. 2 and node signals of the pixel circuit of FIG. 2 in the second period;
FIG. 7 is a circuit diagram illustrating an operation of the pixel circuit of FIG. 2 in a third period of the driving timing;
FIG. 8 is a timing diagram illustrating an example of input signals applied to the pixel circuit of FIG. 2 and node signals of the pixel circuit of FIG. 2 in the third period;
FIG. 9 is a circuit diagram illustrating an operation of the pixel circuit of FIG. 2 in a fourth period of the driving timing;
FIG. 10 is a timing diagram illustrating an example of input signals applied to the pixel circuit of FIG. 2 and node signals of the pixel circuit of FIG. 2 in the fourth period;
FIG. 11 is a circuit diagram illustrating an operation of the pixel circuit of FIG. 2 in a fifth period of the driving timing;
FIG. 12 is a timing diagram illustrating an example of input signals applied to the pixel circuit of FIG. 2 and node signals of the pixel circuit of FIG. 2 in the fifth period;
FIG. 13 is a circuit diagram illustrating a pixel circuit of a display panel of a display apparatus;
FIG. 14 is a circuit diagram illustrating a pixel circuit of a display panel of a display apparatus;
FIG. 15 is a diagram illustrating a driving frequency of the display panel of FIG. 1;
FIG. 16 is a timing diagram illustrating an example of input signals applied to the pixel circuit of FIG. 2 and node signals of the pixel circuit of FIG. 2 in a writing frame;
FIG. 17 is a timing diagram illustrating an example of input signals applied to the pixel circuit of FIG. 2 and node signals of the pixel circuit of FIG. 2 in a holding frame;
FIG. 18 is a timing diagram illustrating an example of input signals applied to the pixel circuit of FIG. 2 and node signals of the pixel circuit of FIG. 2;
FIG. 19 is a block diagram illustrating an electronic apparatus;
FIG. 20 is a diagram illustrating an example in which the electronic apparatus of FIG. 19 is implemented as a smart phone; and
FIG. 21 is a diagram illustrating an example in which the electronic apparatus of FIG. 19 is implemented as a smart watch.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

It will be understood that when an element, layer, region, or component (e.g., an apparatus, a device, a circuit, a wire, an electrode, a terminal, a conductive film, etc.) is referred to as being "formed on," "on," "connected to," or "(operatively, functionally, or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a transistor, a resistor, an inductor, a capacitor, a diode and/or the like. Accordingly, a connection is not limited to the connections illustrated in the drawings or the detailed description and may also include other types of connections. In describing embodiments, an expression of connection indicates electrical connection unless explicitly described to be direct connection, and "directly connected/directly coupled," or "directly on," refers to one component directly connecting or coupling another component, or being on another component, without an intermediate component.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XY, YZ, and XZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list. When "C to D" is stated, it means C or more and D or less, unless otherwise specified.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are only used to distinguish one element, member, component, region, area, layer, section, or portion from another element, member, component, region, area, layer, section, or portion. Thus, a first element, component, region, layer or section described below could be termed a second element, component, region, layer or section, without departing from the spirit and scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

As used herein, the terms "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure." Furthermore, the expression "being the same" may mean "being substantially the same". In other words, the expression "being the same" may include a range that can be tolerated by those of ordinary skill in the art. The other expressions may also be expressions from which "substantially" has been omitted.

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. In addition, each block, unit, and/or module may be implemented by dedicated hardware, or a combination of dedicated hardware that performs some functions and a processor (for example, one or more programmed microprocessors and related circuits) that performs a function different from those of the dedicated hardware. In addition, in some embodiments, the block, unit, and/or module may be physically separated into two or more interact individual blocks, units, and/or modules without departing from the scope of the present disclosure. In addition, in some embodiments, the block, unit and/or module may be physically combined into more complex blocks, units, and/or modules without departing from the scope of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

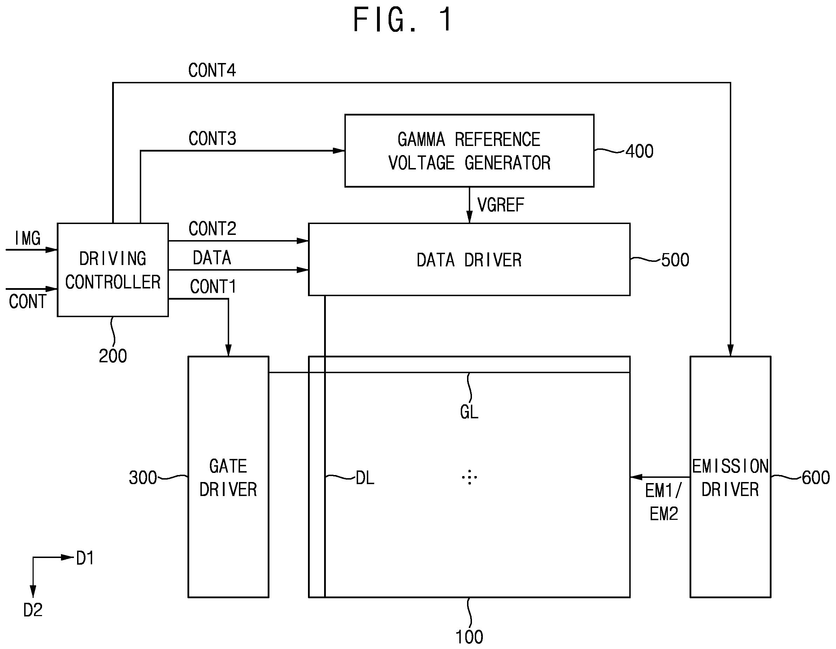

FIG. 1 is a block diagram illustrating a display apparatus.

Referring to FIG. 1, the display apparatus includes a display panel 100 and a display panel driver. The display panel driver includes a driving controller 200, a gate driver 300, a gamma reference voltage generator 400, and a data driver 500. The display panel driver may further include an emission driver 600.

The display panel 100 has a display region on which an image is displayed and a peripheral region adjacent to the display region.

The display panel 100 includes a plurality of gate lines GL, a plurality of data lines DL, and a plurality of pixels electrically connected to the gate lines GL and the data lines DL. The gate lines GL may extend in a first direction D1, and the data lines DL may extend in a second direction D2 crossing the first direction D1.

The driving controller 200 may receive input image data IMG and an input control signal CONT from an external apparatus (e.g. a processor). For example, the input image data IMG may include red image data, green image data, and blue image data. The input image data IMG may include white image data. The input image data IMG may include magenta image data, cyan image data, and yellow image data. The input control signal CONT may include a master clock signal and a data enable signal. The input control signal CONT may further include a vertical synchronizing signal and a horizontal synchronizing signal.

The driving controller 200 generates a first control signal CONT1, a second control signal CONT2, a third control signal CONT3, a fourth control signal CONT4, and a data signal DATA based on the input image data IMG and the input control signal CONT.

The driving controller 200 generates the first control signal CONT1 for controlling an operation of the gate driver 300 based on the input control signal CONT, and outputs the first control signal CONT1 to the gate driver 300. The first control signal CONT1 may include a vertical start signal and a gate clock signal.

The driving controller 200 may generate the second control signal CONT2 for controlling an operation of the data driver 500 based on the input control signal CONT, and may output the second control signal CONT2 to the data driver 500. The second control signal CONT2 may include a horizontal start signal and a load signal.

The driving controller 200 may generate the data signal DATA based on the input image data IMG. The driving controller 200 may output the data signal DATA to the data driver 500.

The driving controller 200 may generate the third control signal CONT3 for controlling an operation of the gamma reference voltage generator 400 based on the input control signal CONT, and may output the third control signal CONT3 to the gamma reference voltage generator 400.

The driving controller 200 may generate the fourth control signal CONT4 for controlling an operation of the emission driver 600 based on the input control signal CONT, and may output the fourth control signal CONT4 to the emission driver 600.

The gate driver 300 may generate gate signals driving the gate lines GL in response to the first control signal CONT1 received from the driving controller 200. The gate driver 300 may output the gate signals to the gate lines GL.

The gate driver 300 may be integrated on the peripheral region of the display panel 100. The gate driver 300 may be mounted on the peripheral region of the display panel 100.

The gamma reference voltage generator 400 may generate a gamma reference voltage VGREF in response to the third control signal CONT3 received from the driving controller 200. The gamma reference voltage generator 400 may provide the gamma reference voltage VGREF to the data driver 500. The gamma reference voltage VGREF has a value corresponding to a level of the data signal DATA.

The gamma reference voltage generator 400 may be located in the driving controller 200, or in the data driver 500.

The data driver 500 may receive the second control signal CONT2 and the data signal DATA from the driving controller 200, and may receive the gamma reference voltages VGREF from the gamma reference voltage generator 400. The data driver 500 converts the data signal DATA into data voltages having an analog type using the gamma reference voltages VGREF. The data driver 500 outputs the data voltages to the data lines DL.

The data driver 500 may be integrated on the peripheral region of the display panel 100. The data driver 500 may be mounted on the peripheral region of the display panel 100.

The emission driver 600 may generate emission signals EM1 and EM2 in response to the fourth control signal CONT4 received from the driving controller 200. The emission driver 600 may output the emission signals EM1 and EM2 to the display panel 100.

The emission driver 600 may be integrated on the peripheral region of the display panel 100. The emission driver 600 may be mounted on the peripheral region of the display panel 100.

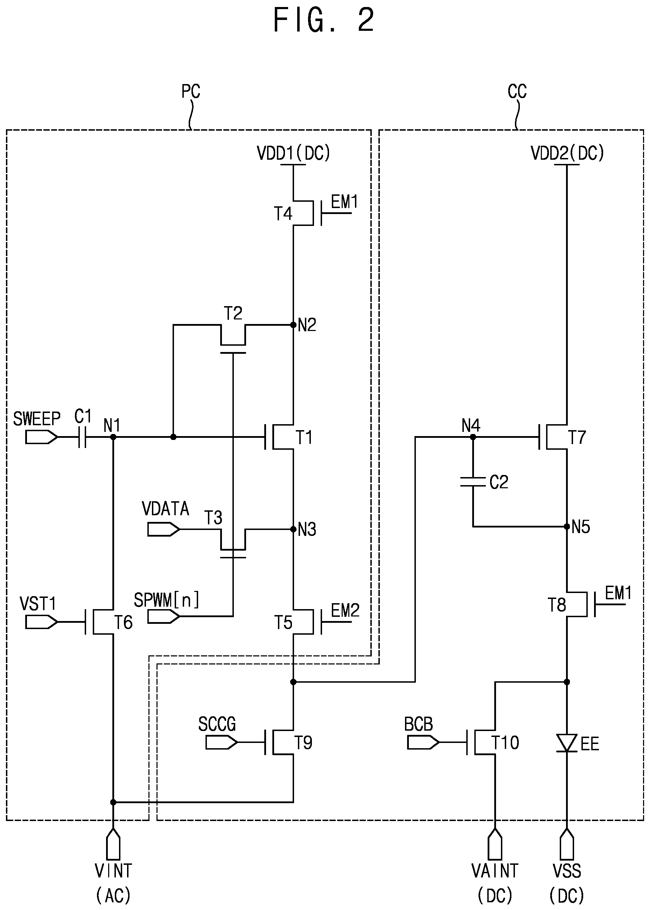

FIG. 2 is a circuit diagram illustrating a pixel circuit of the display panel 100 of FIG. 1.

Referring to FIGS. 1 and 2, the pixel circuit may include a first circuit PC and a second circuit CC. The first circuit PC may be a pulse width modulation circuit for a pulse width modulation (PWM). The second circuit CC may be a constant current generation circuit for a constant current generation (CCG).

The first circuit PC may include first to sixth transistors T1, T2, T3, T4, T5, and T6 and a first capacitor C1. The second circuit CC may include seventh to tenth T7, T8, T9, and T10 and a second capacitor C2. The second circuit CC may include a light-emitting element EE.

For example, the light-emitting element EE may be a light-emitting diode. The light-emitting element EE may be a micro light-emitting diode.

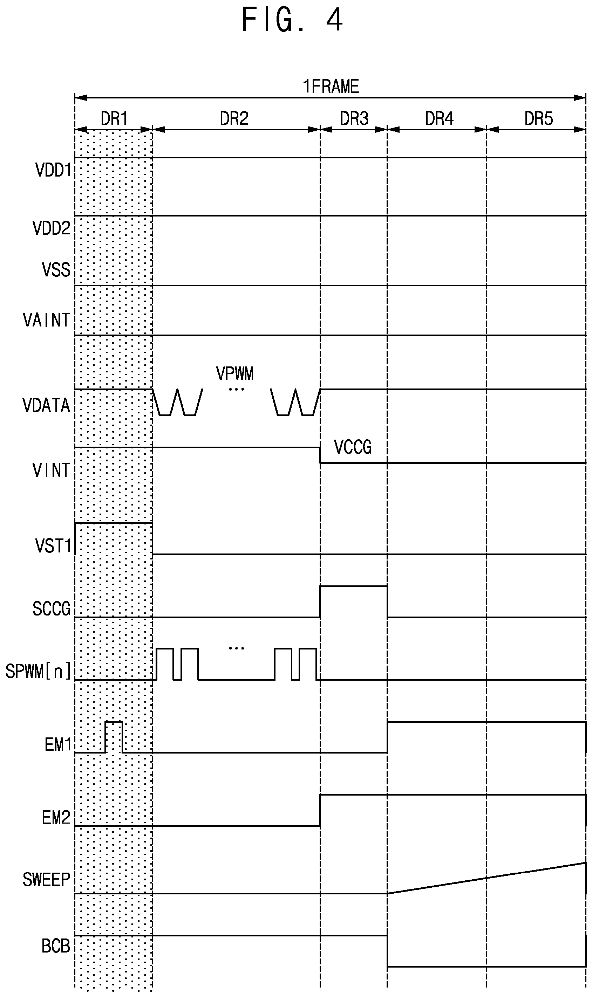

The pixel circuit includes the first transistor T1, the second transistor T2, the third transistor T3, the seventh transistor T7, the ninth transistor T9, and the light-emitting element EE. The first transistor T1 includes a control electrode connected to a first node N1, a first electrode connected to a second node N2, and a second electrode connected to a third node N3. The second transistor T2 is connected to the first node N1 and the second node N2. The third transistor T3 applies a data voltage VDATA (e.g., VPWM of FIG. 4) to the first transistor T1. The seventh transistor T7 is connected to a fourth node N4, and applies a driving current to the light-emitting element EE. The ninth transistor T9 applies a constant-current voltage (e.g., VCCG of FIG. 4) to the fourth node N4. The light-emitting element EE may emit light based on the data voltage VDATA (e.g., VPWM of FIG. 4) and the constant-current voltage (e.g., VCCG of FIG. 4).

The first transistor T1 is an N-type transistor. The seventh transistor T7 is an N-type transistor.

The second transistor T2 may include a control electrode for receiving a first scan signal SPWM[n], a first electrode connected to the first node N1, and a second electrode connected to the second node N2.

The third transistor T3 may include a control electrode for receiving the first scan signal SPWM[n], a first electrode for receiving the data voltage VDATA, and a second electrode connected to the third node N3.

The seventh transistor T7 may include a control electrode connected to the fourth node N4, a first electrode for receiving a second power voltage VDD2, and a second electrode connected to a fifth node N5.

The ninth transistor T9 may include a control electrode for receiving a second scan signal SCCG, a first electrode connected to the fourth node N4, and a second electrode connected to a first initialization voltage terminal.

The light-emitting element EE may include an anode electrode and a cathode electrode. The cathode electrode may receive a third power voltage VSS.

The fourth transistor T4 may include a control electrode for receiving a first emission signal EM1, a first electrode for receiving a first power voltage VDD1, and a second electrode connected to the second node N2.

The fifth transistor T5 may include a control electrode for receiving a second emission signal EM2, a first electrode connected to the third node N3, and a second electrode connected to the fourth node N4.

The sixth transistor T6 may include a control electrode for receiving a first initialization signal VST1, a first electrode connected to the first node N1, and a second electrode connected to the first initialization voltage terminal to receive a first initialization voltage VINT. The second electrode of the sixth transistor T6 may be connected to a second electrode of the ninth transistor T9.

The eighth transistor T8 may include a control electrode for receiving the first emission signal EM1, a first electrode connected to the fifth node N5, and a second electrode connected to the anode electrode of the light-emitting element EE.

The tenth transistor T10 may include a control electrode for receiving a second initialization signal BCB, a first electrode connected to the anode electrode of the light-emitting element EE, and a second electrode for receiving a second initialization voltage VAINT.

The first capacitor C1 may include a first electrode for receiving a sweep signal SWEEP, and a second electrode connected to the first node N1.

The second capacitor C2 may include a first electrode connected to the fourth node N4, and a second electrode connected to the fifth node N5.

As explained above, the pixel circuit may include ten transistors and two capacitors.

The first to tenth transistors T1 to T10 may be N-type transistors. For example, the N-type transistor may be an oxide semiconductor transistor. The first to tenth transistors T1 to T10 are N-type transistors so that a manufacturing process may be simplified.

A first initialization voltage applied to the control electrode of the first transistor T1 and a constant-current voltage applied to the control electrode of the seventh transistor T7 are outputted from the same voltage terminal VINT so that a number of the transistors and a number of the signal lines may be reduced.

The data voltage VDATA (e.g., VPWM of FIG. 4) may have same or different voltage levels depending on intensities of light emission of pixels. In contrast, the constant-current voltage (e.g., VCCG of FIG. 4) may have the same voltage level for all pixels. Alternatively, the constant-current voltage (e.g., VCCG of FIG. 4) may have a first voltage level for red pixels, a second voltage level different from the first voltage level for green pixels, and a third voltage level different from the first voltage level and the second voltage level for blue pixels.

For example, the first power voltage VDD1 and the second power voltage VDD2 may be high power voltages for determining a light emission degree of the light-emitting element EE, and the third power voltage VSS may be a low power voltage for determining the light emission degree of the light-emitting element EE. The first power voltage VDD1 and the second power voltage VDD2 may be greater than the third power voltage VSS.

In addition, the first power voltage VDD1 may be greater than the second power voltage VDD2.

When the first transistor T1 is turned off and the seventh transistor T7 is turned on in a light-emission period, the light-emitting element EE may emit a light. When the first transistor T1 is turned on, and accordingly, the first power voltage VDD1 is applied to the control electrode of the seventh transistor T7 in a light-emission-off period, the seventh transistor T7 may be turned off, and the light-emitting element EE may stop emitting a light.

For example, the second initialization voltage VAINT may be less than the third power voltage VSS. When the second initialization voltage VAINT is less than the third power voltage VSS, a leakage current may be reduced or prevented from flowing through the light-emitting element EE. Thus, a black characteristic of the pixel circuit may be enhanced.

The first scan signal SPWM[n] may be a progressive scan signal having different timings for pixel rows. Herein, [n] may represent an n-th pixel row. The pixel circuit of FIG. 2 receiving the first scan signal SPWM[n] may be a pixel circuit included in the n-th pixel row.

The first initialization signal VST1, the second initialization signal BCB, and the second scan signal SCCG may be global scan signals having the same timing regardless of the pixel row. The first emission signal EM1 and the second emission signal EM2 may be global scan signals having the same timing regardless of the pixel row.

The first power voltage VDD1, the second power voltage VDD2, the third power voltage VSS and the second initialization voltage VAINT may be direct-current voltages. In contrast, the voltage outputted from the first initialization voltage terminal may be an alternating voltage. For example, the voltage outputted from the first initialization voltage terminal may have a first level and a second level. The first level may be the first initialization voltage applied to the control electrode of the first transistor T1. The second level may be the constant-current voltage (e.g., VCCG of FIG. 4) applied to the control electrode of the seventh transistor T7.

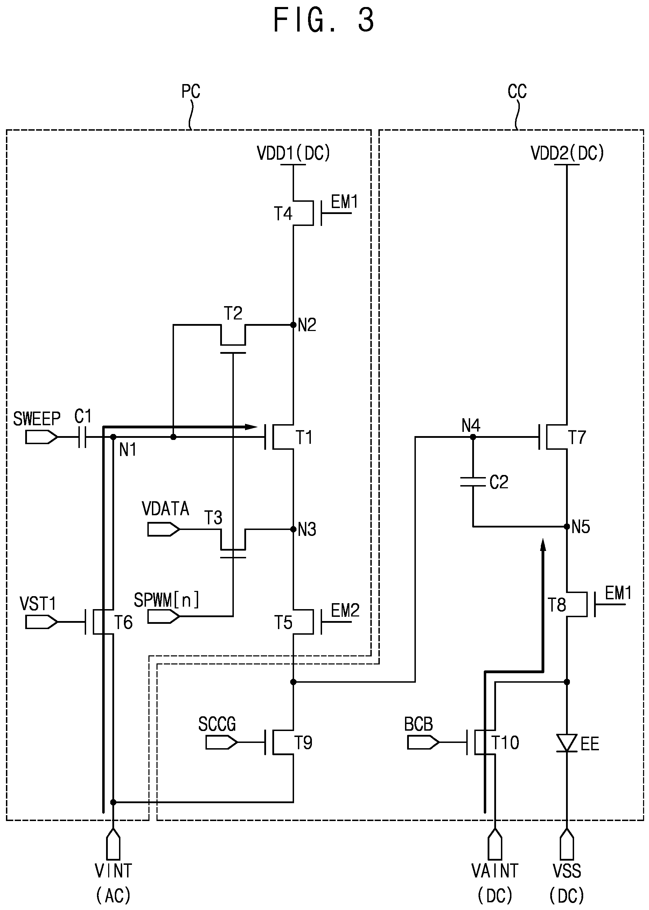

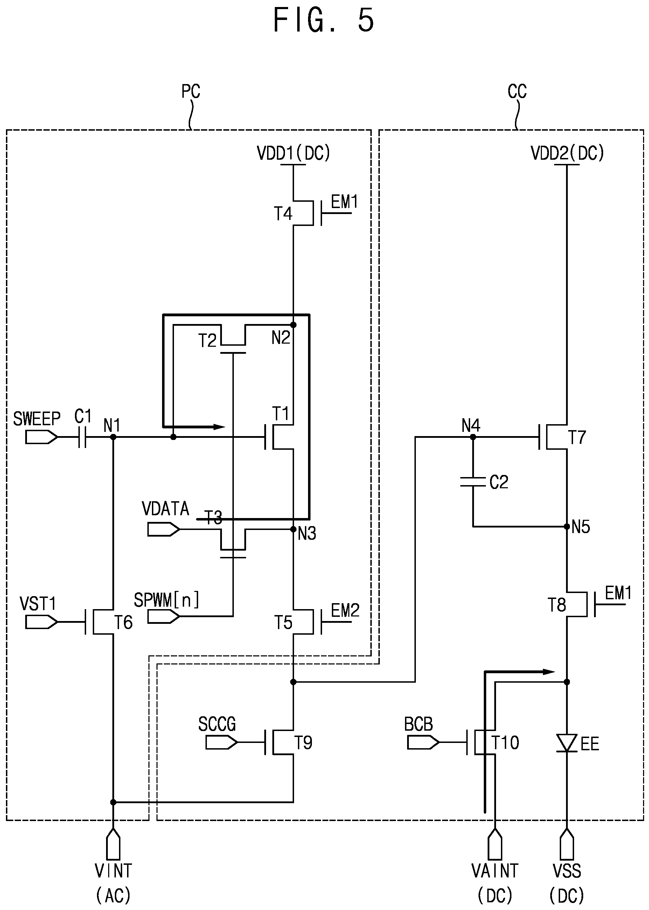

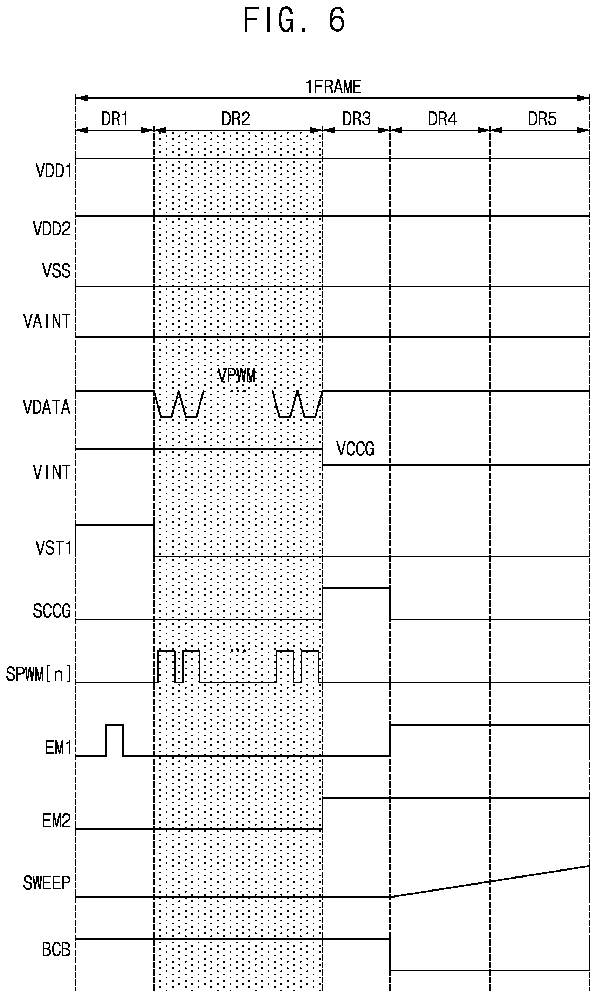

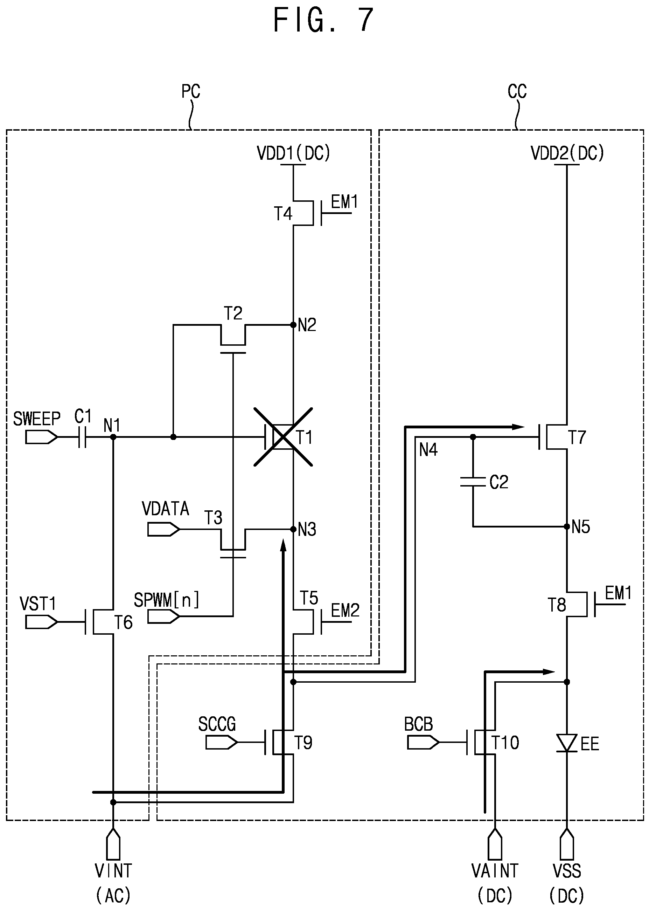

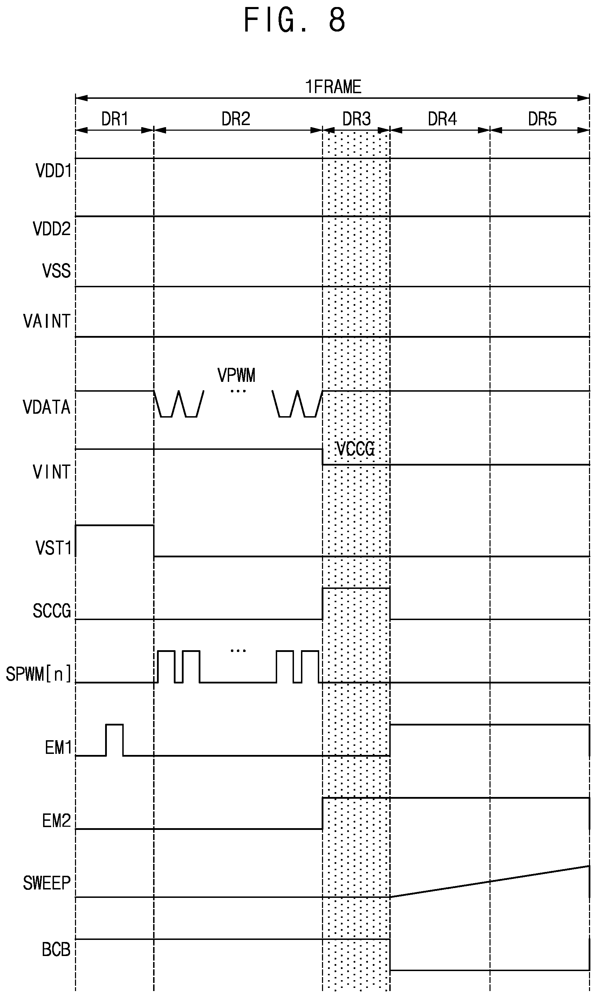

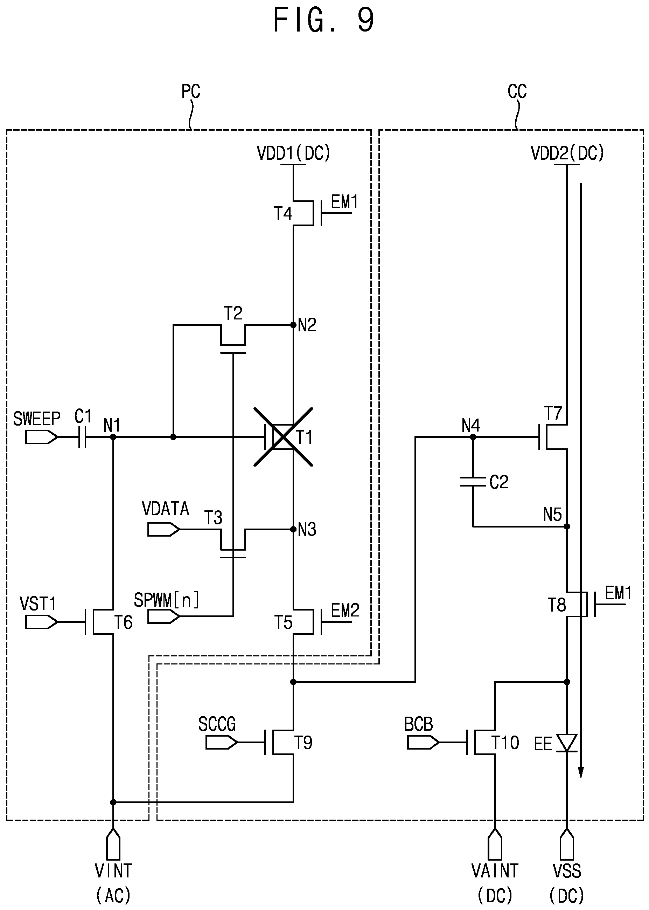

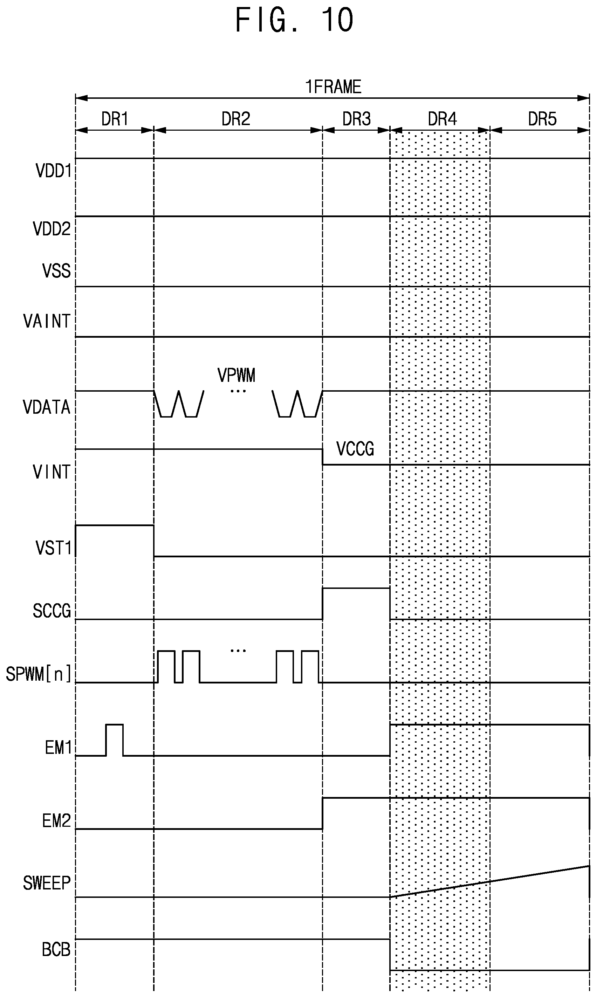

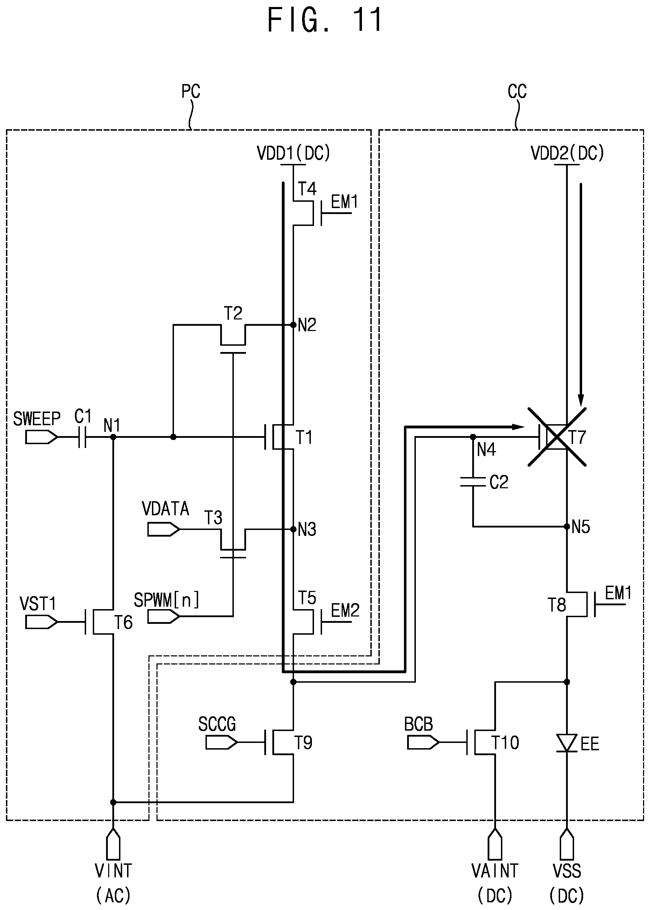

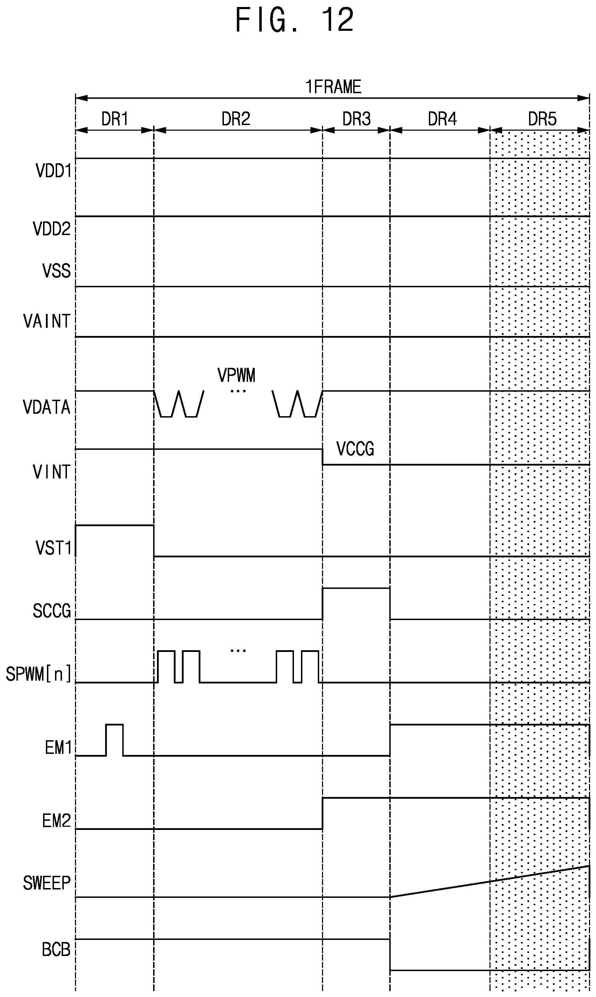

FIG. 3 is a circuit diagram illustrating an operation of the pixel circuit of FIG. 2 in a first period DR1 of a driving timing. FIG. 4 is a timing diagram illustrating an example of input signals applied to the pixel circuit of FIG. 2 and node signals of the pixel circuit of FIG. 2 in the first period DR1. FIG. 5 is a circuit diagram illustrating an operation of the pixel circuit of FIG. 2 in a second period DR2 of the driving timing. FIG. 6 is a timing diagram illustrating an example of input signals applied to the pixel circuit of FIG. 2, and node signals of the pixel circuit of FIG. 2 in the second period DR2. FIG. 7 is a circuit diagram illustrating an operation of the pixel circuit of FIG. 2 in a third period DR3 of the driving timing. FIG. 8 is a timing diagram illustrating an example of input signals applied to the pixel circuit of FIG. 2 and node signals of the pixel circuit of FIG. 2 in the third period DR3. FIG. 9 is a circuit diagram illustrating an operation of the pixel circuit of FIG. 2 in a fourth period DR4 of the driving timing. FIG. 10 is a timing diagram illustrating an example of input signals applied to the pixel circuit of FIG. 2 and node signals of the pixel circuit of FIG. 2 in the fourth period DR4. FIG. 11 is a circuit diagram illustrating an operation of the pixel circuit of FIG. 2 in a fifth period DR5 of the driving timing FIG. 12 is a timing diagram illustrating an example of input signals applied to the pixel circuit of FIG. 2 and node signals of the pixel circuit of FIG. 2 in the fifth period DR5.

In the driving timing, the first period DR1 may be an initialization period, the second period DR2 may be a pulse-width-modulation-data-writing-and-compensation period, the third period DR3 may be a constant-current-voltage-writing period, the fourth period DR4 may be the light-emission period and the fifth period DR5 may be the light-emission-off period.

A width of the fourth period DR4, which is the light-emission period, may be determined by a level of the pulse width modulation data VPWM.

The sweep signal SWEEP may have a constant low level in the first period DR1, the second period DR2, and the third period DR3, and may gradually increase in the fourth period DR4 and the fifth period DR5.

Referring to FIGS. 3 and 4, in the first period DR1, the first initialization signal VST1 may have an active level, the second initialization signal BCB may have an active level, the first scan signal SPWM[n] may have an inactive level, the second scan signal SCCG may have an inactive level, the first emission signal EM1 may have an active pulse, the second emission signal EM2 may have an inactive level, the sweep signal SWEEP may have the low level, and the voltage outputted from the first initialization voltage terminal may have the first level (e.g., the first initialization voltage).

Herein, the transistors for respectively receiving the first initialization signal VST1, the second initialization signal BCB, the first scan signal SPWM[n], the second scan signal SCCG, the first emission signal EM1, and the second emission signal EM2 are N-type transistors, so that the active level may be a high level, and the inactive level may be a low level.

The first period DR1 may be the initialization period. In the initialization period DR1, the sixth transistor T6, the eighth transistor T8, and the tenth transistor T10 may be turned on.

In the initialization period DR1, the control electrode (the first node N1) of the first transistor T1 may be initialized by the first initialization voltage VINT through the sixth transistor T6. The first initialization voltage may be a level to turn on the first transistor T1.

In the initialization period DR1, the anode electrode of the light-emitting element EE may be initialized by the second initialization voltage VAINT through the tenth transistor T10.

In the initialization period DR1, the second electrode (e.g. a source electrode) of the seventh transistor T7 may be initialized by the second initialization voltage VAINT through the tenth transistor T10 and the eighth transistor T8.

Referring to FIGS. 5 and 6, in the second period DR2 subsequent to the first period DR1, the first initialization signal VST1 may have an inactive level, the second initialization signal BCB may have the active level, the first scan signal SPWM[n] may have an active level, the second scan signal SCCG may have the inactive level, the first emission signal EM1 may have the inactive level, the second emission signal EM2 may have the inactive level, and the sweep signal SWEEP may have the low level.

The second period DR2 may be the pulse-width-modulation-data-writing-and-compensation period. In the pulse-width-modulation-data-writing-and-compensation period DR2, the second transistor T2 may be turned on by the first scan signal SPWM[n], the first transistor T1 may be turned on by the first initialization voltage in the initialization period DR1, and the third transistor T3 may be turned on by the first scan signal SPWM[n]. In the pulse-width-modulation-data-writing-and-compensation period DR2, a turned-on state of the tenth transistor T10 may be maintained.

In the pulse-width-modulation-data-writing-and-compensation period DR2, the data voltage VPWM may be applied to the control electrode of the first transistor T1 along a path of the third transistor T3, the first transistor T1, and the second transistor T2. By the second transistor T2, which is diode-connected, a threshold voltage of the first transistor T1 may be compensated in the data voltage VPWM.

Referring to FIGS. 7 and 8, in the third period DR3 subsequent to the second period DR2, the first initialization signal VST1 may have the inactive level, the second initialization signal BCB may have the active level, the first scan signal SPWM[n] may have the inactive level, the second scan signal SCCG may have an active level, the first emission signal EM1 may have the inactive level, the second emission signal EM2 may have an active level, the sweep signal SWEEP may have the low level, and the voltage outputted from the first initialization voltage terminal may have the second level VCCG.

The third period DR3 may be the constant-current-voltage-writing period. In the constant-current-voltage-writing period DR3, the ninth transistor T9 may be turned on by the second scan signal SCCG, and the fifth transistor T5 may be turned on by the second emission signal EM2. In the constant-current-voltage-writing period DR3, the turned-on state of the tenth transistor T10 may be maintained.

In the constant-current-voltage-writing period DR3, the constant-current voltage VCCG may be applied to the control electrode of the seventh transistor T7 through the ninth transistor T9. In the constant-current-voltage-writing period DR3, the constant-current voltage VCCG may be applied to the third node N3 along a path of the ninth transistor T9 and the fifth transistor T5. When the constant-current voltage VCCG is applied to the third node N3, a gate-source voltage Vgs of the first transistor T1 is changed so that the first transistor T1 may be turned off.

Referring to FIGS. 9 and 10, in the fourth period DR4 subsequent to the third period DR3, the first initialization signal VST1 may have the inactive level, the second initialization signal BCB may have an inactive level, the first scan signal SPWM[n] may have the inactive level, the second scan signal SCCG may have the inactive level, the first emission signal EM1 may have an active level, the second emission signal EM2 may have the active level, and the sweep signal SWEEP may gradually increase from the low level.

For example, the voltage outputted from the first initialization voltage terminal may have a first level in the first period DR1, and a second level that is different from the first level in the third period DR3. The first level may be a voltage for initializing the control electrode of the first transistor T1, and the second level VCCG may be a voltage for initializing the control electrode of the seventh transistor T7.

The fourth period DR4 may be the light-emission period. In the light-emission period DR4, the fourth transistor T4 and the eighth transistor T8 may be turned on by the first emission signal EM1, the seventh transistor T7 may be turned on by the constant-current voltage VCCG, and the fifth transistor T5 may be turned on by the second emission signal EM2.

In the light-emission period DR4, a current may flow along a path of the eighth transistor T8, the seventh transistor T7, and the light-emitting element EE so that the light-emitting element EE may emit a light.

Referring to FIGS. 11 and 12, in the fifth period DR5 subsequent to the fourth period DR4, the first initialization signal VST1 may have the inactive level, the second initialization signal BCB may have the inactive level, the first scan signal SPWM[n] may have the inactive level, the second scan signal SCCG may have the inactive level, the first emission signal EM1 may have the active level, the second emission signal EM2 may have the active level, and the sweep signal SWEEP may gradually increase following the fourth period DR4.

The fifth period DR5 may be the light-emission-off period. As the sweep signal SWEEP increases, the first transistor T1 may be turned on at a corresponding time point. The time point when the first transistor T1 is turned on may be determined by the data voltage VPWM applied to the control electrode of the first transistor T1.

When the first transistor T1 is turned on, the first power voltage VDD1 is applied to the control electrode of the seventh transistor T7 along a path of the fourth transistor T4, the first transistor, and the fifth transistor T5.

When the first power voltage VDD1 is applied to the control electrode of the seventh transistor T7, the seventh transistor T7 may be turned off, and the light-emitting element EE may stop emitting a light.

The pixel circuit may include ten transistors and two capacitors. The pixel circuit may be driven in the pulse width modulation method, may operate the internal compensation of the threshold voltage, and may include the relatively fewer transistors compared to the conventional pixel circuit, so that the high integration may be achieved. Thus, the pixel circuit may be applicable to an ultra-high resolution display apparatus.

In addition, the driving transistor T1 of the pulse width modulation circuit PC is an N-type transistor so that an afterimage characteristic, a response time characteristic when changing from a black image to a white image, and/or a luminance-changing-rate characteristic according to a temperature may be enhanced.

In addition, the driving transistor T7 of the constant-current-generating circuit CC is an N-type transistor, so that the afterimage characteristic, the response time characteristic when changing from the black image to the white image, and/or the luminance-changing-rate characteristic according to the temperature may be enhanced.

In addition, the pixel circuit need not include a P-type transistor, but only N-type transistors, so that a manufacturing process may be simplified compared to a manufacturing process of a pixel circuit including both an N-type transistor and a P-type transistor.

In addition, the second initialization voltage VAINT applied to the second electrode of the tenth transistor T10 is less than the third power voltage VSS applied to the cathode electrode of the light-emitting element EE, so that a black characteristic of the pixel circuit may be enhanced.

In addition, the first initialization voltage applied to the control electrode of the first transistor T1, and the constant-current voltage VCCG applied to the control electrode of the seventh transistor T7, are outputted from the same voltage terminal, so that a number of transistors and a number of signal lines may be reduced.

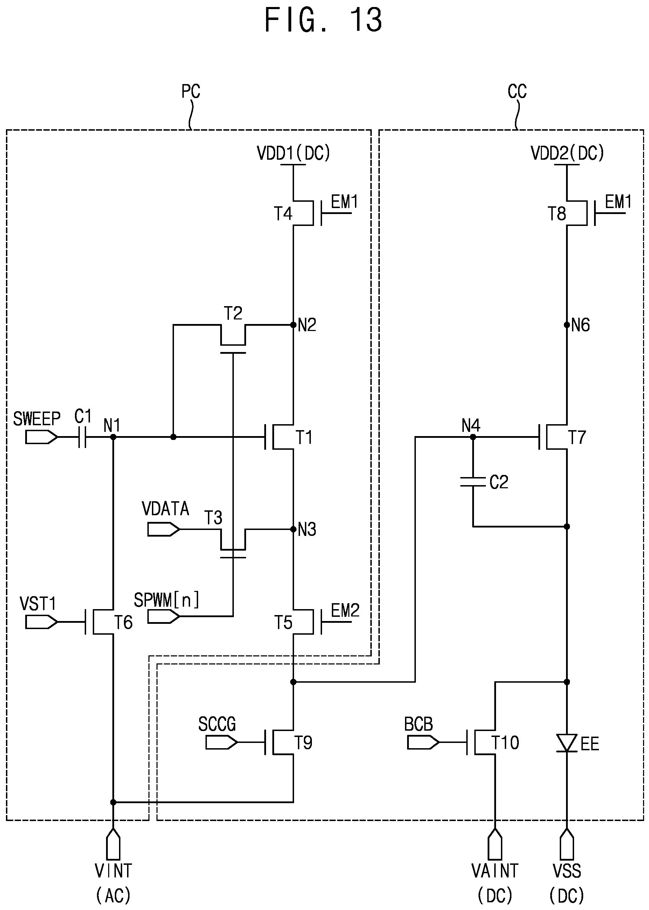

FIG. 13 is a circuit diagram illustrating a pixel circuit of a display panel 100 of a display apparatus.

The pixel circuit shown in FIG. 13 is substantially the same as the pixel circuit of the previous examples explained referring to FIG. 2 except for a position of the eighth transistor. Thus, the same reference numerals will be used to refer to the same or like parts as those described in the previous examples, and any repetitive explanation concerning the above elements will be omitted.

Referring to FIGS. 1 and 3 to 13, the pixel circuit includes the first transistor T1, the second transistor T2, the third transistor T3, the seventh transistor T7, the ninth transistor T9, and the light-emitting element EE. The first transistor T1 includes a control electrode connected to a first node N1, a first electrode connected to a second node N2, and a second electrode connected to a third node N3. The second transistor T2 is connected to the first node N1 and the second node N2. The third transistor T3 applies a data voltage VDATA (e.g., VPWM of FIG. 4) to the first transistor T1. The seventh transistor T7 is connected to a fourth node N4, and applies a driving current to the light-emitting element EE. The ninth transistor T9 applies a constant-current voltage (e.g., VCCG of FIG. 4) to the fourth node N4. The light-emitting element EE emits a light based on the data voltage VDATA (e.g., VPWM of FIG. 4) and the constant-current voltage (e.g., VCCG of FIG. 4).

The first transistor T1 is an N-type transistor. The seventh transistor T7 is an N-type transistor.

The seventh transistor T7 may include a control electrode connected to the fourth node N4, a first electrode connected to a sixth node N6, and a second electrode connected to an anode electrode of the light-emitting element EE.

The eighth transistor T8 may include a control electrode for receiving the first emission signal EM1, a first electrode for receiving a second power voltage VDD2, and a second electrode connected to the sixth node N6.

The pixel circuit may include ten transistors and two capacitors. The pixel circuit may be driven in the pulse width modulation method, may operate the internal compensation of the threshold voltage, and may include the relatively fewer transistors compared to the conventional pixel circuit, so that the high integration may be achieved. Thus, the pixel circuit may be applicable to an ultra-high resolution display apparatus.

In addition, the driving transistor T1 of the pulse width modulation circuit PC is an N-type transistor so that an afterimage characteristic, a response time characteristic when changing from a black image to a white image, and/or a luminance-changing-rate characteristic according to a temperature may be enhanced.

In addition, the driving transistor T7 of the constant-current-generating circuit CC is an N-type transistor so that the afterimage characteristic, the response time characteristic when changing from the black image to the white image, and/or the luminance-changing-rate characteristic according to the temperature may be enhanced.

In addition, the pixel circuit may omit P-type transistors, and may instead include only N-type transistors so that a manufacturing process may be simplified compared to a manufacturing process of a pixel circuit including both an N-type transistor and a P-type transistor.

In addition, the second initialization voltage VAINT applied to the second electrode of the tenth transistor T10 is less than the third power voltage VSS applied to the cathode electrode of the light-emitting element EE, so that a black characteristic of the pixel circuit may be enhanced.

In addition, the first initialization voltage applied to the control electrode of the first transistor T1 and the constant-current voltage VCCG applied to the control electrode of the seventh transistor T7 are outputted from the same voltage terminal so that a number of transistors and a number of signal lines may be reduced.

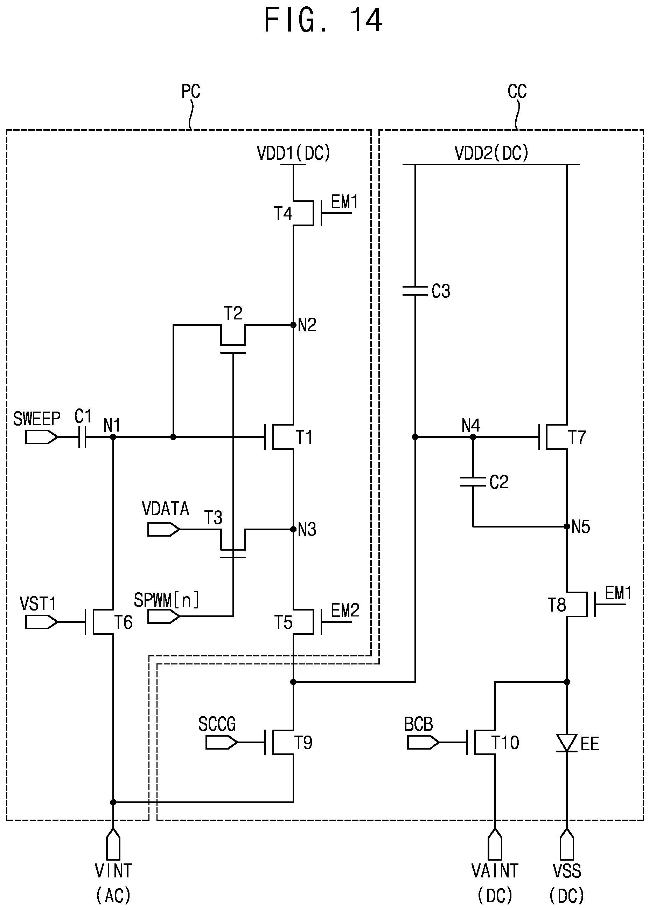

FIG. 14 is a circuit diagram illustrating a pixel circuit of a display panel 100 of a display apparatus.

The pixel circuit shown in FIG. 14 is substantially the same as the pixel circuit of the previous examples explained referring to FIG. 2 except that the pixel circuit further includes a third capacitor C3. Thus, the same reference numerals will be used to refer to the same or like parts as those described in the previous examples and any repetitive explanation concerning the above elements will be omitted.

Referring to FIGS. 1, 3 to 12, and 14, the pixel circuit includes the first transistor T1, the second transistor T2, the third transistor T3, the seventh transistor T7, the ninth transistor T9 and the light-emitting element EE. The first transistor T1 includes a control electrode connected to a first node N1, a first electrode connected to a second node N2, and a second electrode connected to a third node N3. The second transistor T2 is connected to the first node N1 and the second node N2. The third transistor T3 applies a data voltage VDATA (e.g., VPWM of FIG. 4) to the first transistor T1. The seventh transistor T7 is connected to a fourth node N4 and applies a driving current to the light-emitting element EE. The ninth transistor T9 applies a constant-current voltage (e.g., VCCG of FIG. 4) to the fourth node N4. The light-emitting element EE emits a light based on the data voltage VDATA (e.g., VPWM of FIG. 4) and the constant-current voltage (e.g., VCCG of FIG. 4).

The first transistor T1 is an N-type transistor. The seventh transistor T7 is an N-type transistor.

The seventh transistor T7 may include a control electrode connected to the fourth node N4, a first electrode for receiving a second power voltage VDD2, and a second electrode connected to a fifth node N5.

The pixel circuit may further include a third capacitor C3 including a first electrode for receiving the second power voltage VDD2, and a second electrode connected to the fourth node N4. When the pixel circuit further includes the third capacitor C3, the voltage of the control electrode of the seventh transistor T7 may be stably maintained so that a noise may be reduced and a stain may be reduced.

The pixel circuit may include ten transistors and three capacitors. The pixel circuit may be driven in the pulse width modulation method, may operate the internal compensation of the threshold voltage, and may include the relatively fewer transistors compared to the conventional pixel circuit, so that the high integration may be achieved. Thus, the pixel circuit may be applicable to an ultra-high resolution display apparatus.

In addition, the driving transistor T1 of the pulse width modulation circuit PC is an N-type transistor so that an afterimage characteristic, a response time characteristic when changing from a black image to a white image, and/or a luminance-changing-rate characteristic according to a temperature may be enhanced.

In addition, the driving transistor T7 of the constant-current-generating circuit CC is an N-type transistor so that the afterimage characteristic, the response time characteristic when changing from the black image to the white image, and/or the luminance-changing-rate characteristic according to the temperature may be enhanced.

In addition, the pixel circuit may omit P-type transistors, and may instead include only N-type transistors so that a manufacturing process may be simplified compared to a manufacturing process of a pixel circuit including both an N-type transistor and a P-type transistor.

In addition, the second initialization voltage VAINT applied to the second electrode of the tenth transistor T10 is less than the third power voltage VSS applied to the cathode electrode of the light-emitting element EE, so that a black characteristic of the pixel circuit may be enhanced.

In addition, the first initialization voltage applied to the control electrode of the first transistor T1 and the constant-current voltage VCCG applied to the control electrode of the seventh transistor T7 are outputted from the same voltage terminal, so that a number of transistors and a number of signal lines may be reduced.

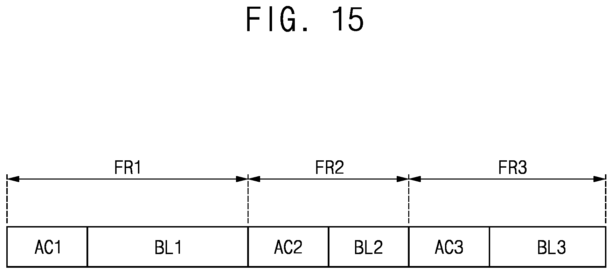

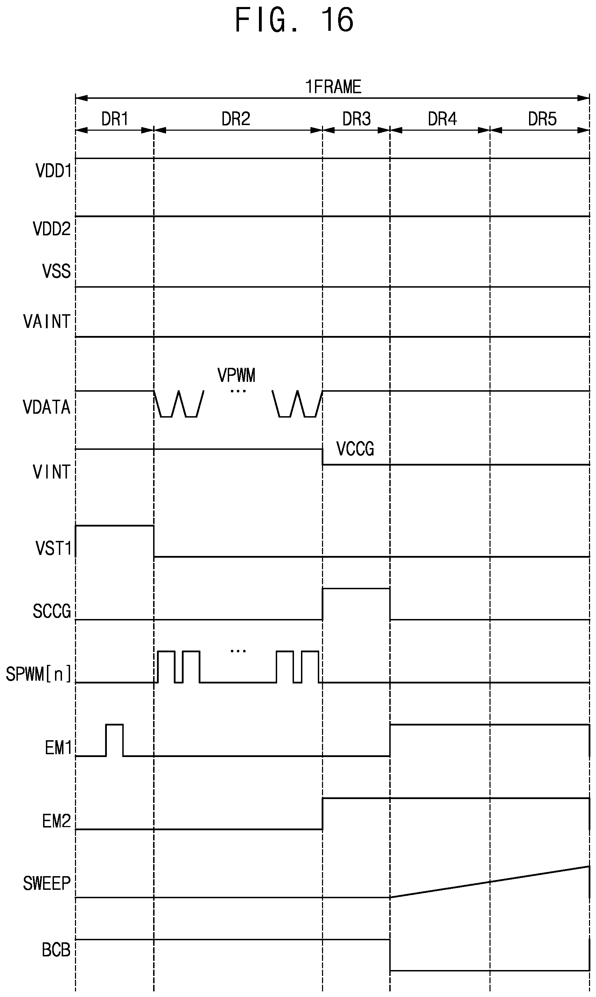

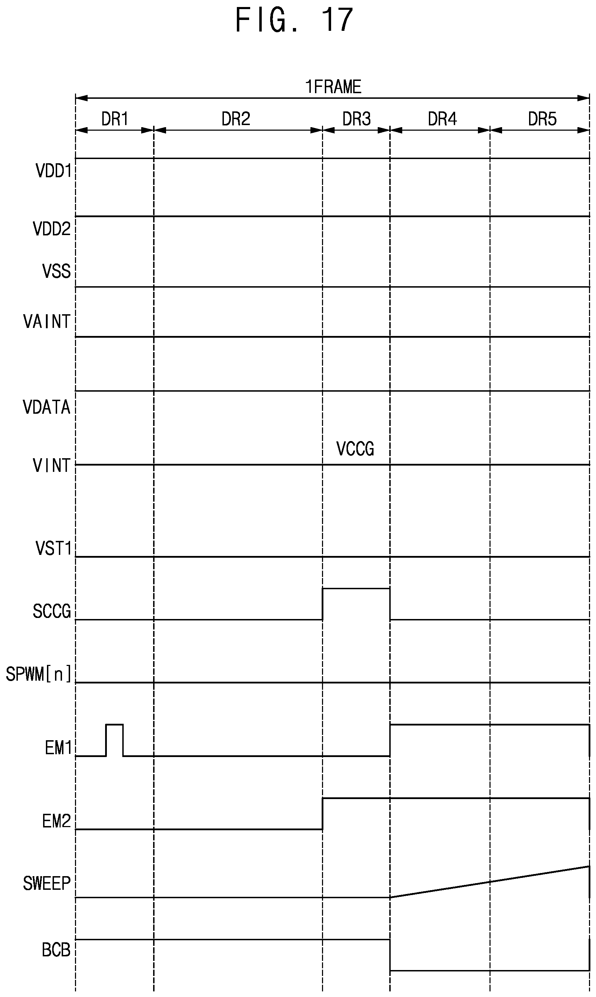

FIG. 15 is a diagram illustrating a driving frequency of the display panel 100 of FIG. 1. FIG. 16 is a timing diagram illustrating an example of input signals applied to the pixel circuit of FIG. 2 and node signals of the pixel circuit of FIG. 2 in a writing frame. FIG. 17 is a timing diagram illustrating an example of input signals applied to the pixel circuit of FIG. 2 and node signals of the pixel circuit of FIG. 2 in a holding frame.

The driving timing of the pixel circuit is substantially the same as the driving timing of the previous examples explained referring to FIGS. 4, 6, 8, 10, and 12 except that the display panel 100 is driven in a variable frequency. Thus, the same reference numerals will be used to refer to the same or like parts as those described in the previous examples, and any repetitive explanation concerning the above elements will be omitted.

Referring to FIGS. 1, 2, and 15 to 17, the display panel 100 may be driven in a variable frequency. A first frame FR1 having a first frequency may include a first active period AC1 and a first blank period BL1. A second frame FR2 having a second frequency that is different from the first frequency may include a second active period AC2 and a second blank period BL2. A third frame FR3 having a third frequency that is different from the first frequency and the second frequency may include a third active period AC3 and a third blank period BL3.

The first active period AC1 may have a length that is substantially the same as a length of the second active period AC2. The first blank period BL1 may have a length that is different from a length of the second blank period BL2.

The second active period AC2 may have the length that is substantially the same as a length of the third active period AC3. The second blank period BL2 may have the length that is different from a length of the third blank period BL3.

The display apparatus supporting the variable frequency may include a writing frame in which the data voltage is written to the pixel, and a holding frame in which only light emission is operated without writing the data voltage to the pixel. The writing frame may be in the active period AC1, AC2 and AC3. The holding frame may be in the blank period BL1, BL2 and BL3.

For example, in the writing frame, the data voltage VPWM may be applied to the first transistor T1, and the light-emitting element EE may emit a light. For example, in the holding frame, the data voltage VPWM may not be applied to the first transistor T1 and the light-emitting element EE may emit a light.

In the driving timing of the writing frame of FIG. 16, the first period DR1 may be an initialization period, the second period DR2 may be a pulse-width-modulation-data-writing-and-compensation period, the third period DR3 may be a constant-current-voltage-writing period, the fourth period DR4 may be a light-emission period, and the fifth period DR5 may be a light-emission-off period. The driving timing of the writing frame of FIG. 16 may be substantially the same as the driving timings of FIGS. 4, 6, 8, 10, and 12.

In the driving timing of the holding frame of FIG. 17, the first period DR1 may be an initialization period, the second period DR2 may be a pulse-width-modulation-data-writing-and-compensation period, the third period DR3 may be a constant-current-voltage-writing period, the fourth period DR4 may be a light-emission period, and the fifth period DR5 may be a light-emission-off period. In the holding frame, the voltage VDATA of a data voltage terminal maintains a constant level, the voltage VINT of the first initialization terminal may maintain the second level VCCG, the first initialization signal VST1 may maintain an inactive level, and the first scan signal SPWM[n] may maintain an inactive level.

In the first period (DR1 of FIG. 16) of the writing frame, the first initialization signal VST1 may have an active level. In the second period (DR2 of FIG. 16) of the writing frame, the first scan signal SPWM[n] may have an active pulse. In the first period (DR1 of FIG. 17) of the holding frame in which the data voltage VPWM is not applied to the first transistor T1, and in which the light-emitting element EE emits a light, the first initialization signal VST1 may have an inactive level. In the second period (DR2 of FIG. 17) of the holding frame, the first scan signal SPWM[n] may have an inactive level.

The pixel circuit may include ten transistors and two capacitors. The pixel circuit may be driven in the pulse width modulation method, may operate the internal compensation of the threshold voltage, and may include relatively fewer transistors compared to the conventional pixel circuit, so that the high integration may be achieved. Thus, the pixel circuit may be applicable to an ultra-high resolution display apparatus.

In addition, the driving transistor T1 of the pulse width modulation circuit PC is an N-type transistor, so that an afterimage characteristic, a response time characteristic when changing from a black image to a white image, and/or a luminance-changing-rate characteristic according to a temperature may be enhanced.

In addition, the driving transistor T7 of the constant-current-generating circuit CC is an N-type transistor so that the afterimage characteristic, the response time characteristic when changing from the black image to the white image, and/or the luminance-changing-rate characteristic according to the temperature may be enhanced.

In addition, the pixel circuit may omit P-type transistors, and may instead include only N-type transistors so that a manufacturing process may be simplified compared to a manufacturing process of a pixel circuit including both an N-type transistor and a P-type transistor.

In addition, the second initialization voltage VAINT applied to the second electrode of the tenth transistor T10 is less than the third power voltage VSS applied to the cathode electrode of the light-emitting element EE, so that a black characteristic of the pixel circuit may be enhanced.

In addition, the first initialization voltage applied to the control electrode of the first transistor T1 and the constant-current voltage VCCG applied to the control electrode of the seventh transistor T7 are outputted from the same voltage terminal, so that a number of transistors and a number of signal lines may be reduced.

In addition, the pixel circuit may support a variable frequency driving method so that the power consumption of the display apparatus may be reduced.

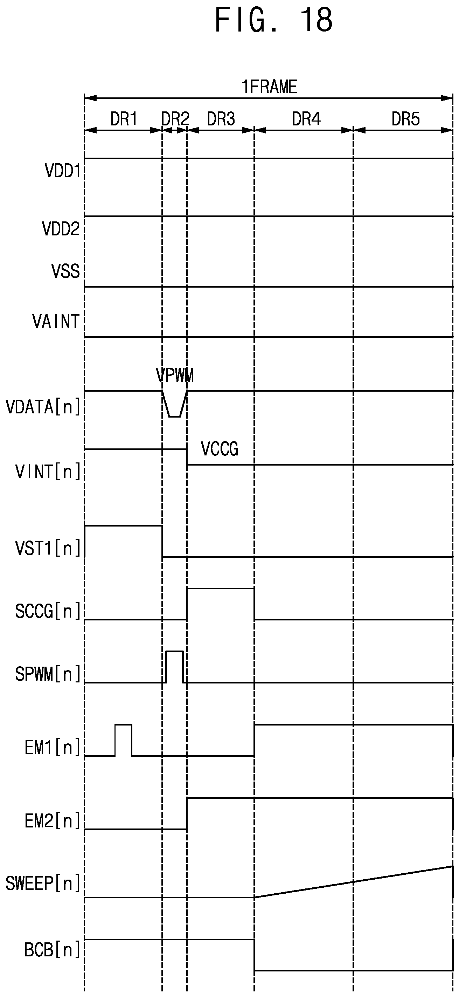

FIG. 18 is a timing diagram illustrating an example of input signals applied to the pixel circuit of FIG. 2 and node signals of the pixel circuit of FIG. 2.

The driving timing of the pixel circuit is substantially the same as the driving timing of the previous examples explained referring to FIGS. 4, 6, 8, 10, and 12 except that the display panel 100 is driven in a progressive light emission driving method. Thus, the same reference numerals will be used to refer to the same or like parts as those described in the previous examples and any repetitive explanation concerning the above elements will be omitted.

Referring to FIGS. 1, 2, and 18, the display panel 100 may be driven in a progressive light emission driving method.

In a driving timing, a first period DR1 may be an initialization period, a second period DR2 may be a pulse-width-modulation-data-writing-and-compensation period, a third period DR3 may be a constant-current-voltage-writing period, a fourth period DR4 may be a light-emission period, and a fifth period DR5 may be a light-emission-off period.

The first initialization signal VST1[n], the second initialization signal BCB[n], the first scan signal SPWM[n], the second scan signal SCCG[n], the first emission signal EM1[n], the second emission signal EM2[n], and the sweep signal SWEEP[n] may be progressive scan signals having different timings for pixel rows. Herein, [n] may represent an n-th pixel row.

The first initialization signal VST1[n], the second initialization signal BCB[n], the first scan signal SPWM[n], the second scan signal SCCG[n], the first emission signal EM1[n], the second emission signal EM2[n] and the sweep signal SWEEP[n] may be progressively applied to the pixel rows.

In addition, the voltage VDATA[n] of the data voltage terminal and the voltage VINT[n] of the first initialization voltage terminal may be progressively applied to the pixel rows.

The pixel circuit may include ten transistors and two capacitors. The pixel circuit may be driven in the pulse width modulation method, may operate the internal compensation of the threshold voltage, and may include the relatively fewer transistors compared to the conventional pixel circuit, so that the high integration may be achieved. Thus, the pixel circuit may be applicable to an ultra-high resolution display apparatus.

In addition, the driving transistor T1 of the pulse width modulation circuit PC is an N-type transistor so that an afterimage characteristic, a response time characteristic when changing from a black image to a white image, and/or a luminance-changing-rate characteristic according to a temperature may be enhanced.

In addition, the driving transistor T7 of the constant-current-generating circuit CC is an N-type transistor so that the afterimage characteristic, the response time characteristic when changing from the black image to the white image, and/or the luminance-changing-rate characteristic according to the temperature may be enhanced.

In addition, the pixel circuit may omit P-type transistors, and may instead include only N-type transistors so that a manufacturing process may be simplified compared to a manufacturing process of a pixel circuit including both an N-type transistor and a P-type transistor.

In addition, the second initialization voltage VAINT applied to the second electrode of the tenth transistor T10 is less than the third power voltage VSS applied to the cathode electrode of the light-emitting element EE, so that a black characteristic of the pixel circuit may be enhanced.

In addition, the first initialization voltage applied to the control electrode of the first transistor T1 and the constant-current voltage VCCG applied to the control electrode of the seventh transistor T7 are outputted from the same voltage terminal, so that a number of transistors and a number of signal lines may be reduced.

In addition, the pixel circuit may be driven in the progressive light emission driving method.

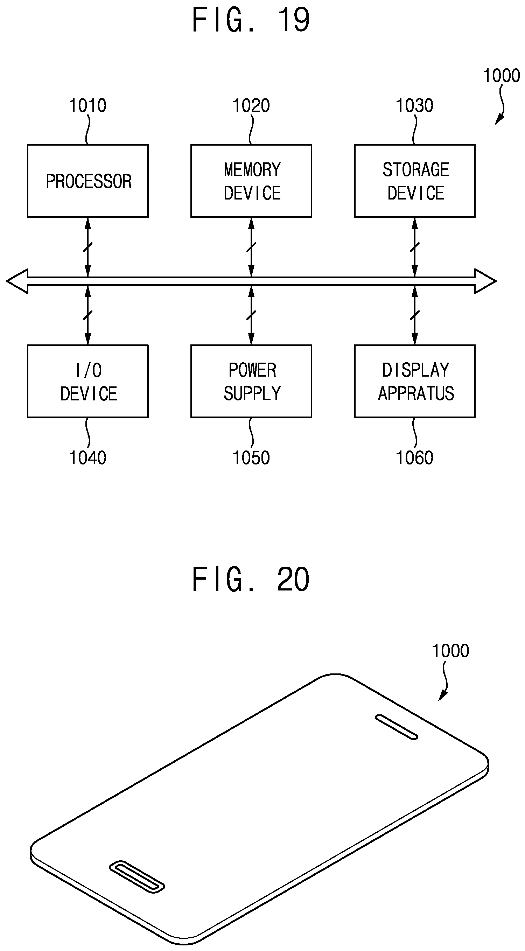

FIG. 19 is a block diagram illustrating an electronic apparatus 1000. FIG. 20 is a diagram illustrating an example in which the electronic apparatus 1000 of FIG. 19 is implemented as a smart phone.

Referring to FIGS. 19 and 20, the electronic apparatus 1000 may include a processor 1010, a memory device 1020, a storage device 1030, an input/output (I/O) device 1040, a power supply 1050, and a display apparatus 1060. Here, the display apparatus 1060 may be the display apparatus of FIG. 1. In addition, the electronic apparatus 1000 may further include a plurality of ports for communicating with a video card, a sound card, a memory card, a universal serial bus (USB) device, other electronic apparatuses, etc.

As illustrated in FIG. 20, the electronic apparatus 1000 may be implemented as a smart phone. However, the electronic apparatus 1000 is not limited thereto. For example, the electronic apparatus 1000 may be implemented as a cellular phone, a video phone, a smart pad, a smart watch, a tablet PC, a car navigation system, a computer monitor, a laptop, a head-mounted display (HMD) device, and the like.

The processor 1010 may perform various computing functions or various tasks. The processor 1010 may be a micro-processor, a central processing unit (CPU), an application processor (AP), and the like. The processor 1010 may be coupled to other components via an address bus, a control bus, a data bus, etc. Further, the processor 1010 may be coupled to an extended bus such as a peripheral component interconnection (PCI) bus.

The processor 1010 may output the input image data IMG and the input control signal CONT to the driving controller 200 of FIG. 1.

The memory device 1020 may store data for operations of the electronic apparatus 1000. For example, the memory device 1020 may include at least one non-volatile memory device, such as an erasable programmable read-only memory (EPROM) device, an electrically erasable programmable read-only memory (EEPROM) device, a flash memory device, a phase change random access memory (PRAM) device, a resistance random access memory (RRAM) device, a nano floating gate memory (NFGM) device, a polymer random access memory (PoRAM) device, a magnetic random access memory (MRAM) device, a ferroelectric random access memory (FRAM) device, and/or the like and/or at least one volatile memory device such as a dynamic random access memory (DRAM) device, a static random access memory (SRAM) device, a mobile DRAM device, and/or the like.

The storage device 1030 may include a solid state drive (SSD) device, a hard disk drive (HDD) device, a CD-ROM device, and the like. The I/O device 1040 may include an input device such as a keyboard, a keypad, a mouse device, a touch-pad, a touch-screen, and the like and an output device such as a printer, a speaker, and the like. The display apparatus 1060 may be included in the I/O device 1040. The power supply 1050 may provide power for operations of the electronic apparatus 1000. The display apparatus 1060 may be coupled to other components via the buses or other communication links.

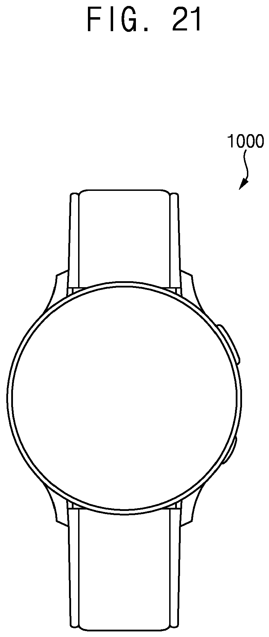

FIG. 21 is a diagram illustrating an example in which the electronic apparatus 1000 of FIG. 19 is implemented as a smart watch.

Referring to FIGS. 19 and 21, the electronic apparatus 1000 may be implemented as a smart watch. The smart watch may be an example of the electronic apparatus 1000 requiring an ultra-high resolution display panel.

According to the pixel circuit, the display apparatus and the electronic apparatus of the present disclosure as explained above, the ultra-high resolution display apparatus may be implemented using the pixel circuit having the high integration.

The foregoing is illustrative of the present disclosure and is not to be construed as limiting thereof. Although a few embodiments of the present disclosure have been described, those skilled in the art will readily appreciate that many modifications are possible in the embodiments without materially departing from the novel teachings and advantages of the present disclosure. Accordingly, all such modifications are intended to be included within the scope of the present invention as defined in the claims.

## Claims

1. A pixel circuit comprising:
a first transistor (T1) comprising a control electrode connected to a first node (N1), a first electrode connected to a second node (N2), and a second electrode connected to a third node (N3);
a second transistor (T2) connected to the first node and the second node;
a third transistor (T3) configured to apply a data voltage to the first transistor;
a seventh transistor (T7) connected to a fourth node (N4), and configured to apply a driving current to a light-emitting element (EE); and
a ninth transistor (T9) configured to apply a constant-current voltage to the fourth node;
wherein the light-emitting element is configured to emit light based on the data voltage and the constant-current voltage, and
wherein the first transistor, the second transistor, the third transistor, the seventh transistor, and the ninth transistor comprise N-type transistors.

2. The pixel circuit of claim 1, further comprising a sixth transistor (T6) comprising a control electrode configured to receive a first initialization signal (VST1), a first electrode connected to the first node, and a second electrode connected to a first initialization voltage terminal (VINT) and to a second electrode of the ninth transistor.

3. The pixel circuit of claim 1 or 2, further comprising a first capacitor (C1) comprising a first electrode configured to receive a sweep signal, and a second electrode connected to the first node.

4. The pixel circuit of claim 1, 2 or 3, further comprising:
a fourth transistor (T4) comprising a control electrode configured to receive a first emission signal (EM1), a first electrode configured to receive a first power voltage (VDD1), and a second electrode connected to the second node; and
a fifth transistor (T5) comprising a control electrode configured to receive a second emission signal (EM2), a first electrode connected to the third node (N3), and a second electrode connected to the fourth node (N4).

5. The pixel circuit of any one of claims 1 to 4, further comprising an eighth transistor (T8) comprising a control electrode configured to receive a first emission signal (EM1), a first electrode connected to a second electrode of the seventh transistor (T7), and a second electrode connected to an anode electrode of the light-emitting element, or further comprising an eighth transistor comprising a control electrode configured to receive a first emission signal, a first electrode configured to receive a second power voltage, and a second electrode connected to a first electrode of the seventh transistor.

6. The pixel circuit of any one of the preceding claims, further comprising a tenth transistor (T10) comprising a control electrode configured to receive a second initialization signal, a first electrode connected to an anode electrode of the light-emitting element, and a second electrode configured to receive a second initialization voltage.

7. The pixel circuit of any one of the preceding claims, further comprising a second capacitor (C2) comprising a first electrode connected to the fourth node, and a second electrode connected to a second electrode of the seventh transistor, and/ or further comprising a third capacitor (C3) comprising a first electrode configured to receive a second power voltage, and a second electrode connected to the fourth node.

8. The pixel circuit of any one of the preceding claims, wherein when the first transistor is configured to be turned off, the seventh transistor is configured to be turned on, and the light-emitting element is configured to emit a light in a light-emission period, and
wherein the first transistor is configured to be turned on, the seventh transistor is configured to be turned off, and the light-emitting element is configured to stop emitting light in a light-emission-off period.

9. The pixel circuit of any one of claims 1 to 3, further comprising a fourth transistor comprising a control electrode configured to receive a first emission signal, a first electrode configured to receive a first power voltage, and a second electrode connected to the second node,
wherein a second power voltage is configured to be applied to a first electrode of the seventh transistor, and
wherein the first power voltage is greater than the second power voltage.

10. The pixel circuit of any one of claims 1 to 5, further comprising a tenth transistor comprising a control electrode configured to receive a second initialization signal, a first electrode connected to an anode electrode of the light-emitting element, and a second electrode configured to receive a second initialization voltage,
wherein a third power voltage is configured to be applied to a cathode electrode of the light-emitting element, and
wherein the second initialization voltage is less than the third power voltage.

11. The pixel circuit of any one of claims 1 to 3, wherein the second transistor comprises a control electrode configured to receive a first scan signal, a first electrode connected to the first node, and a second electrode connected to the second node,
wherein the third transistor comprises a control electrode configured to receive the first scan signal, a first electrode configured to receive the data voltage, and a second electrode connected to the third node,
wherein the seventh transistor comprises a control electrode connected to the fourth node, a first electrode configured to receive a second power voltage, and a second electrode connected to a fifth node,
wherein the ninth transistor comprises a control electrode configured to receive a second scan signal, a first electrode connected to the fourth node, and a second electrode connected to a first initialization voltage terminal, and
wherein the light-emitting element comprises an anode electrode, and a cathode electrode configured to receive a third power voltage.

12. The pixel circuit of claim 11, further comprising:
a fourth transistor comprising a control electrode configured to receive a first emission signal, a first electrode configured to receive a first power voltage, and a second electrode connected to the second node;
a fifth transistor comprising a control electrode configured to receive a second emission signal, a first electrode connected to the third node, and a second electrode connected to the fourth node;
a sixth transistor comprising a control electrode configured to receive a first initialization signal, a first electrode connected to the first node, and a second electrode connected to the first initialization voltage terminal;
an eighth transistor comprising a control electrode configured to receive the first emission signal, a first electrode connected to the fifth node, and a second electrode connected to the anode electrode of the light-emitting element;
a tenth transistor comprising a control electrode configured to receive a second initialization signal, a first electrode connected to the anode electrode of the light-emitting element, and a second electrode configured to receive a second initialization voltage;
a first capacitor comprising a first electrode configured to receive a sweep signal, and a second electrode connected to the first node; and
a second capacitor comprising a first electrode connected to the fourth node, and a second electrode connected to the fifth node, optionally wherein the fourth transistor, the fifth transistor, the sixth transistor, the eighth transistor, and the tenth transistor comprise N-type transistors.

13. The pixel circuit of claim 12, wherein the first initialization signal has an active level in a first period,
wherein the second initialization signal has an active level in the first period,
wherein the first scan signal has an inactive level in the first period,
wherein the second scan signal has an inactive level in the first period,
wherein the first emission signal has an active pulse in the first period,
wherein the second emission signal has an inactive level in the first period,
wherein the sweep signal has a low level in the first period, and
wherein a voltage outputted from the first initialization voltage terminal has a first level in the first period, or
wherein the first initialization signal has an inactive level in a second period,
wherein the second initialization signal has an active level in the second period,
wherein the first scan signal has an active pulse in the second period,
wherein the second scan signal has an inactive level in the second period,
wherein the first emission signal has an inactive level in the second period,
wherein the second emission signal has an inactive level in the second period, and
wherein the sweep signal has a low level in the second period, or
wherein the first initialization signal has an inactive level in a third period,
wherein the second initialization signal has an active level in the third period,
wherein the first scan signal has an inactive level in the third period,
wherein the second scan signal has an active level in the third period,
wherein the first emission signal has an inactive level in the third period,
wherein the second emission signal has an active level in the third period,
wherein the sweep signal has a low level in the third period, and
wherein a voltage outputted from the first initialization voltage terminal has a second level in the third period, or
wherein the first initialization signal has an inactive level in a fourth period and a fifth period,
wherein the second initialization signal has an inactive level in the fourth period and the fifth period,
wherein the first scan signal has an inactive level in the fourth period and the fifth period,
wherein the second scan signal has an inactive level in the fourth period and the fifth period,
wherein the first emission signal has an active level in the fourth period and the fifth period,
wherein the second emission signal has an active level in the fourth period and the fifth period, and
wherein the sweep signal is configured to gradually increase from a low level in the fourth period and the fifth period, or
wherein the first initialization signal has an active level in a first period,
wherein the second scan signal has an active level in a third period, and
wherein a voltage outputted from the first initialization voltage terminal has a first level in the first period, and a second level different from the first level in the third period, or
wherein the second scan signal has an active level in a third period,
wherein the first emission signal has an inactive level in the third period, and
wherein the second emission signal has an active level in the third period.

14. The pixel circuit of claim 12, wherein the data voltage is to be applied to the first transistor, and the light-emitting element is configured to emit light, in a writing frame,
wherein the first initialization signal has an active level in a first period of the writing frame,
wherein the first scan signal has an active pulse in a second period of the writing frame,
wherein the data voltage is not applied to the first transistor, and the light-emitting element is configured to emit a light, in a holding frame,
wherein the first initialization signal has an inactive level in a first period of the holding frame, and
wherein the first scan signal has an inactive level in a second period of the holding frame.

15. The pixel circuit of claim 12, wherein the first initialization signal, the second initialization signal, the first scan signal, the second scan signal, the first emission signal, the second emission signal, and the sweep signal are configured to be progressively applied to pixel rows.
